# EUROPEAN PATENT APPLICATION

(11) **EP 0 744 765 A1**
(43) Date of publication of application: **27.11.1996**
(21) Application number: 96303631.4
(22) Date of filing: 21.05.1996
(51) Int. Cl.: H01L 21/00

(54) **Apparatus for storing and carrying semiconductor wafers**

(30) Priority: 22.05.1995 US 446981
(71) Applicant: SYMBIOS LOGIC INC., Fort Collins, Colorado 80525 (US)
(72) Inventor: Thornberg, Gary R., Colorado Springs, CO 80906 (US)
(74) Representative: Gill, David Alan

(57) **Abstract**

The invention provides for apparatus for storing and carrying a plurality of wafers (27) comprising a portable housing (11) that has an exterior with a portal leading to an interior portion of the portable housing. The interior has first and second sides that are substantially parallel to each other. The portal is configured to receive a plurality of wafers (27) and the portal is aligned along a plane. The apparatus also includes grooves (25) located in the interior of the portable housing. The grooves (25) are configured to slidably receive the wafers (27) which are then held in a position that is perpendicular to the plane along which the portal lies. In normal use, the wafers (27) are held in a horizontal position when placed within the housing between the grooves. A door (29) is adapted to cover the portal with a seal being created when the door covers the portal. This seal prevents particles from entering the interior of the portable housing from the exterior.

## Description

The present invention relates to apparatus for storing and carrying semiconductor wafers.

In this manner, the present invention can relate generally to microchip fabrication and in particular to an apparatus for use in semiconductor processing.

Solid-state devices are manufactured, many at a time, on disks of semiconducting materials called wafers or slices. During wafer fabrication, the devices or integrated circuits are actually formed on the wafer surface. Up to several thousand identical devices can be formed on each wafer. The area of the wafer occupied by a discrete device or integrated circuit is called a chip or die. The process followed to manufacture these chips or dies is called "fabrication", "fab", "chip fabrication", "semiconductor fabrication", or "microchip fabrication".

Of interest in semiconductor fabrication is device processing yield. Semiconductor devices are vulnerable to various types of contaminants. These contaminants fall into the following major classes: particles, metal ions, chemicals, and bacteria. Semiconductor devices are vulnerable because of the small feature sizes and the thinness of deposited layers on the wafer surface. These various dimensions are in the submicron range. The small physical dimensions of the devices make them very vulnerable to airborne particulate contamination that may originate from workers, equipment, and processing chemicals.

Processing devices in a contaminated environment can cause various problems. For example, contaminants may change the dimension of device parts, change the cleanliness of the surfaces, and may cause pitted layers. Undetected particles and other contaminations may cause changes in electrical performance of devices which may not show up until post fabrication testing.

Normal air is laden with contaminants that must be removed before the air enters a clean room in which semiconductor manufacturing occurs. A major problem is airborne particles, which are also called "aerosols". Normal air contains large amounts of small dust and particles that float and remain in the air for long periods of time. Air quality is designated by a class number, as defined by Federal Standard 209B entitled *Clean Room and Work Station Requirements,* Federal Standard 209B, Sec. 1-5, April 24, 1973, Office of Technical Surfaces, Department of Commerce, Washington D.C. This standard designates air quality in two categories: particle size and density.

To meet this air quality standard and produce contamination free wafers, clean rooms employ various mechanisms to reduce or eliminate particular contaminants. Some of the mechanisms employed to eliminate particulate contamination include special construction materials, adhesive floor mats, air pressure to prevent entry of airborne particles, air showers, and double-door pass throughs. Furthermore, sealed mechanical interface ("SMIF") pods have been employed to reduce the chance of contamination during transport and storage of wafers.

Current SMIF pods for transporting and storing wafers have been designed for encompassing three inch (7.62cm), six inch (15.24cm), and eight inch (20.32cm) wafers. The manufacturing apparatus associated with handling these pods is designed specifically to handle SMIF pods containing wafer sizes of eight inches (20.32cm) and less.

With 12-inch (30.48cm) wafers becoming more common, and the anticipated use of 16-inch (40.64cm) wafers, many semiconductor process tool manufactures have begun designing next generation tools to handle these larger wafers. Twelveinch (30.48cm) wafers will be employed in many environments which involve the use of SMIF pods.

A typical SMIF pod is a housing that is configured to open from the bottom and receive a cassette. The wafers are placed within the cassette, which is in turn placed in the SMIF pod for transportation and storage on shelves in a clean room. The size and weight of a SMIF pod, cassette, and wafer combination increases with each wafer size increase. These changes cause increased storage space requirements and ergonomical issues in handling the larger SMIF pods and cassettes.

The use of SMIF pods and cassettes designed for 12-inch (30.48cm) wafers would impact current fabs and the design of future fabs. In particular, more alterations to current fabs would be required with a cassette stored in a SMIF pod. More storage space and larger equipment would be some of the factors that would have be considered in upgrading or building a new fab. Therefore, it would be advantageous to have an improved apparatus for transporting and storing wafers.

Known apparatus for storing and carrying a plurality of wafers is however disadvantageously restrictive.

According to the present invention, there is provided apparatus for storing and carrying a plurality of wafers comprising portable housing means including an exterior with a portal leading to an interior, the portal being configured to receive the plurality of wafers and characterized by receiving means, mounted in the interior of the portable housing means, for receiving the plurality of wafers, and sealing means for creating a seal over the portal.

The present invention, is particularly advantageous in that an improved pod can be provided in which a separate cassette is eliminated and wafers are loaded and unloaded directly to, or from, the pod.

The present invention can therefore provide an advantageous apparatus for storing and carrying wafers. The apparatus includes a portable housing that has an exterior with a portal leading to an interior portion of the portable housing. The interior has first and second sides that are substantially parallel to each other. The portal is configured to receive a plurality of wafers and the portal is aligned along a plane. The apparatus also includes grooves located in the interior of the portable housing. These grooves are configured to slidably receive wafers. The wafers are held in a position that is perpendicular to the plane along which the portal lies. In normal use, the wafers are held in a horizontal position when placed within the housing between the grooves. A door is adapted to cover the portal with a seal being created when the door covers the portal. This seal prevents particles from entering the interior of the portable housing from the exterior.

A sealing mechanism is employed to create the seal. The apparatus also includes a bumper located on the internal side of the door which is configured to hold the wafers in place when the door is coupled to, and covers, the portal.

The invention can therefore also provide an apparatus for storing and carrying a plurality of wafers, the apparatus comprising a portable housing having an exterior with a portal leading to an interior of the portable housing, the portal being configured to receive the plurality of wafers, a plurality of opposing grooves located within the interior of the portable housing, the plurality of opposing grooves being configured such that said plurality of wafers may be slidably received between the plurality of opposing grooves, and a door configured to be coupled to the portal, wherein a seal preventing particles from entering the portable housing is created when the door is coupled to the portal.

Further, the invention can provide an appratus for storing and carrying a plurality of wafers, the apparatus comprising a portable housing having an exterior with a portal leading to an interior of the portable housing, the portal being configured to allow placement of the plurality of wafers within the interior, a plurality of grooves located within the interior of the portable housing, wherein each of plurality of grooves is configured to slidably receive a wafer, and a door configured to be coupled to the portal and cover the portal, wherein a seal is created when the door is coupled to the portal.

The invention is described further hereinafter, by way of example only, by reference to the accompanying drawings in which:
Fig.1 is a perspective view of a wafer storage and transportation apparatus embodying the present invention;
Fig.2 is a lateral cross-sectional view of the wafer storage and transportation apparatus of Fig. 1;
Fig.3 is a bottom view of the wafer storage and transportation apparatus of Fig. 1;
Fig.4 is a front view of the wafer storage and transportation apparatus of Fig. 1 with the door in place;
Fig.5 is a side view of the wafer storage and transportation apparatus of Fig. 1 with the door in place;
Fig.6 is a top view of a door liner for a wafer storage and transportation apparatus embodying the present invention;
Fig.7 is a side view of the door liner of Fig. 6 Fig.8 is a front view of the wafer storage and transportation apparatus of Fig. 1 with the door removed and configured to hold 25 wafers;
Fig.9 is an enlarged view of a portion of the wafer storage and transportation apparatus as shown in Fig. 8;
Fig.10 is a front view of a wafer storage and transportation apparatus embodying the present invention and configured to hold 5 wafers;
Fig.11 is a front view of another wafer storage and transportation apparatus embodying the present invention and configured to hold 5 wafers; and
Fig.12 is an enlarged view of a portion of the wafer storage and transportation apparatus as shown in Fig. 11.

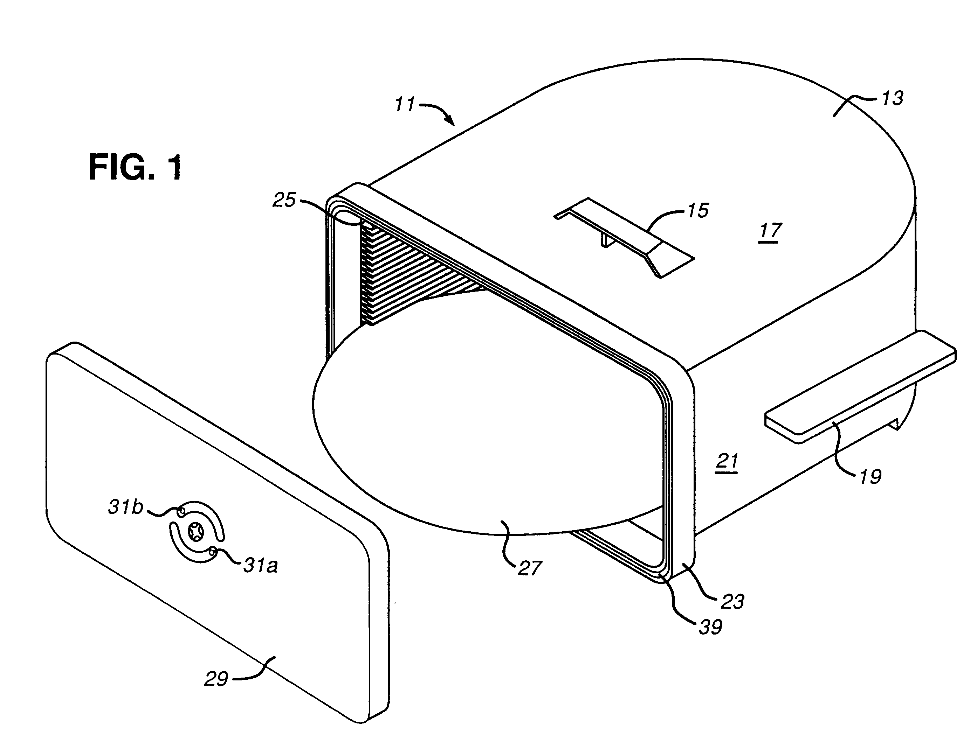

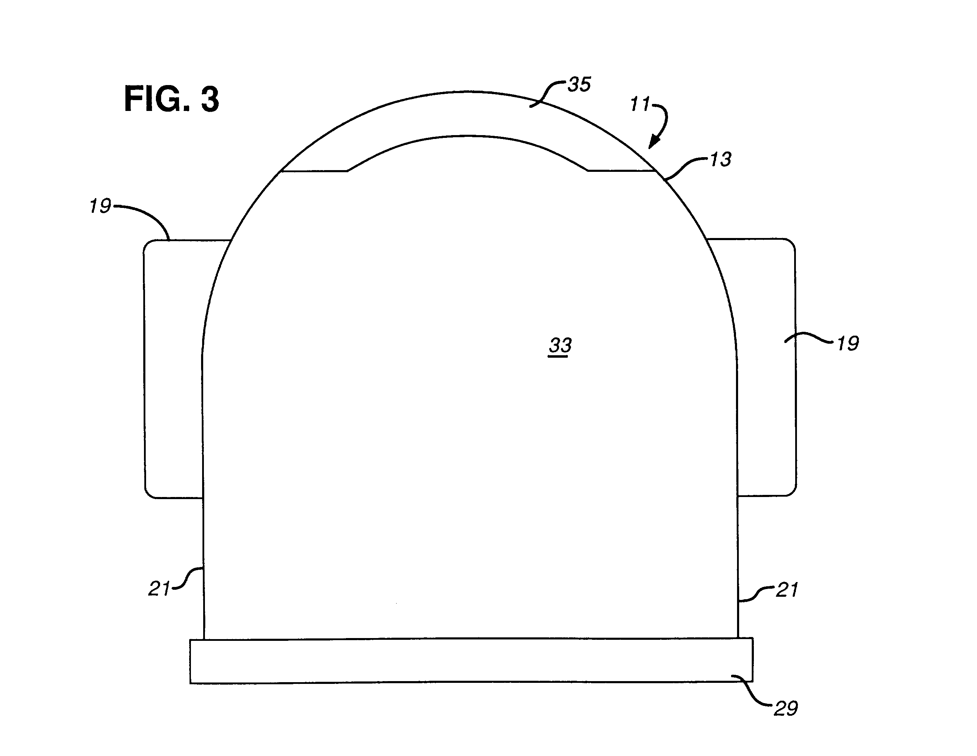

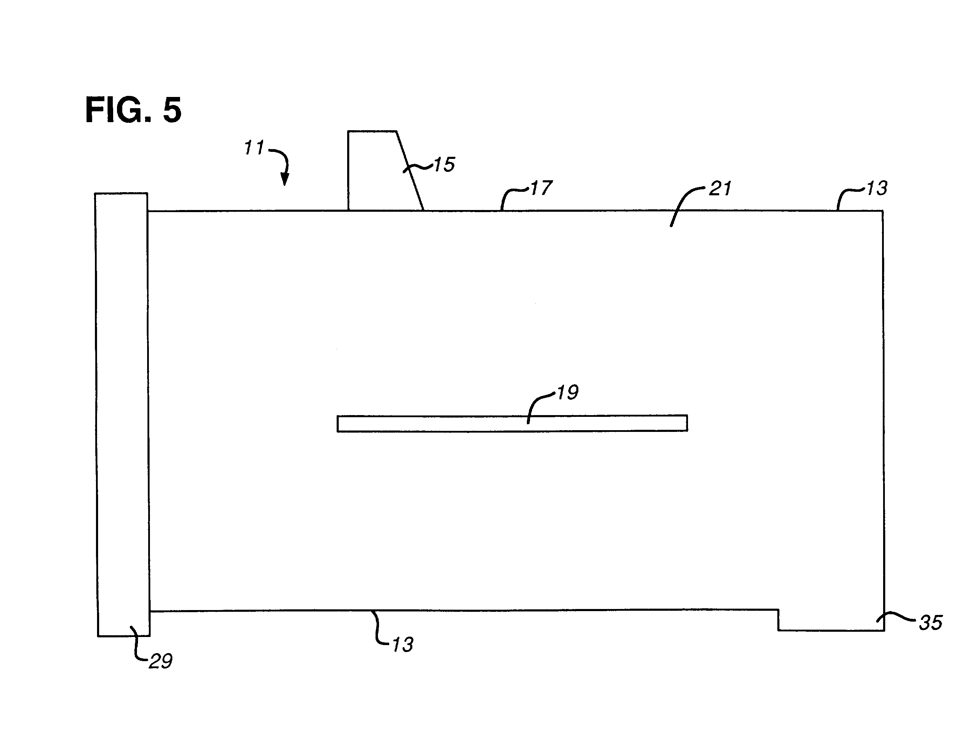

With reference to Figs.1-6, perspective, top cross-sectional, bottom, front, and side views of wafer storage and transportation apparatus embodying the present invention are shown. As illustrated in Fig.1, apparatus 11 includes a housing 13. Housing 13 is portable and includes a handle 15 that is attached to a portion top 17 of the housing 13. Projections 19 extend from sidewalls 21 as can be seen in these figures. Also, sidewall 21 have curved sidewall portions that are configured to fit around the radius of a wafer, such as wafer 27.

Housing 13 has an opening or portal defined by a raised periphery 23. Grooves 25 formed in a liner or insert within housing 13 are provided for holding the wafer 27. Grooves 25 are wedge shaped grooves, i.e. taper inwardly and are employed to slidably receive the wafer 27, along with other wafers (not shown). Alternatively, grooves 25 may be formed as an integral part of the interior of the housing 13. Although the grooves are wedge shaped, other shapes could be employed to slidably receive and retain wafers such as the wafer 27. Each groove runs along the sidewall 21 from one side of the housing 13, around the back of the housing 13, and to the opposite side of the housing 13, as in the depicted example. Housing 13 and grooves 25 may be formed from various materials, such as polypropylene or clear plastic, such as plexiglass. One requirement for materials used for forming the housing 13 and the grooves 25 is that the material does not generate particles during use or storage of the device.

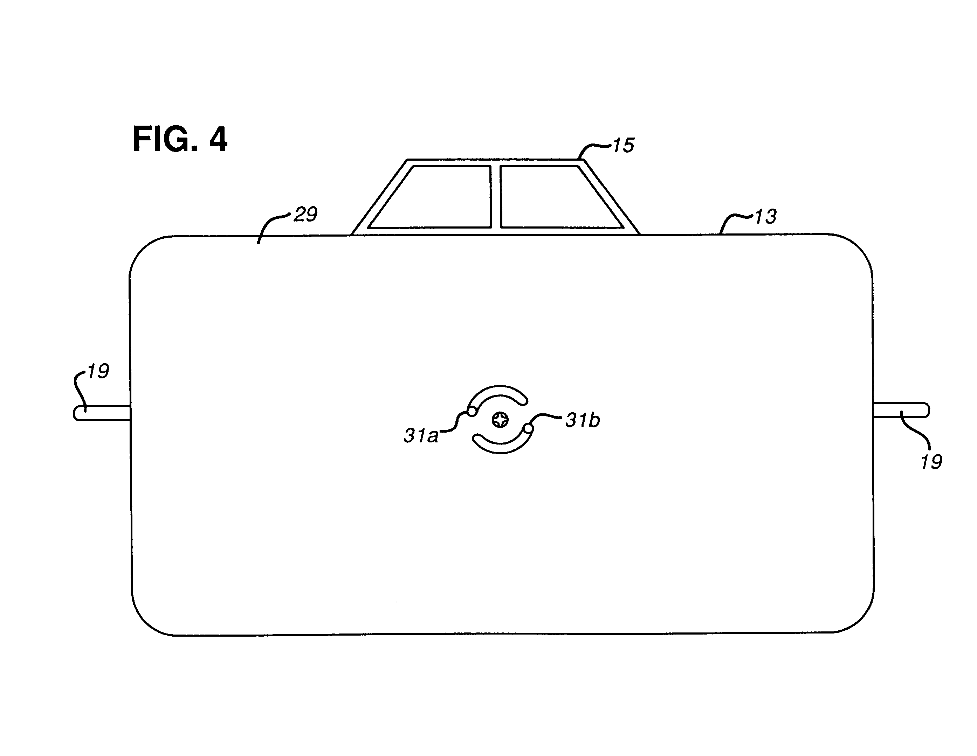

Apparatus 11 also includes a door 29, which is configured to fit around the raised periphery 23 to form a seal that prevents entry of particles from the exterior of the housing 13 to the interior of the housing 13. As can be seen with reference to Figs. 1 and 4, the door 29 includes a sealing mechanism that is engaged and disengaged by members 31a and 31b. This sealing mechanism is a sealed mechanical interface known to those of ordinary skill in the art. In the depicted example, a sealed mechanical interface from presently available SMIF pods is employed. The type of sealed mechanical interface may be selected for use in either a vacuum or non-vacuum application.

Bottom side 33 of the housing 13 includes a shoulder 35 that is raised such that wafers stored within housing 13 are stored in a horizontal position when the door 29 has been coupled with the housing 13, and the housing 13 is placed on a horizontal surface according to the present invention.

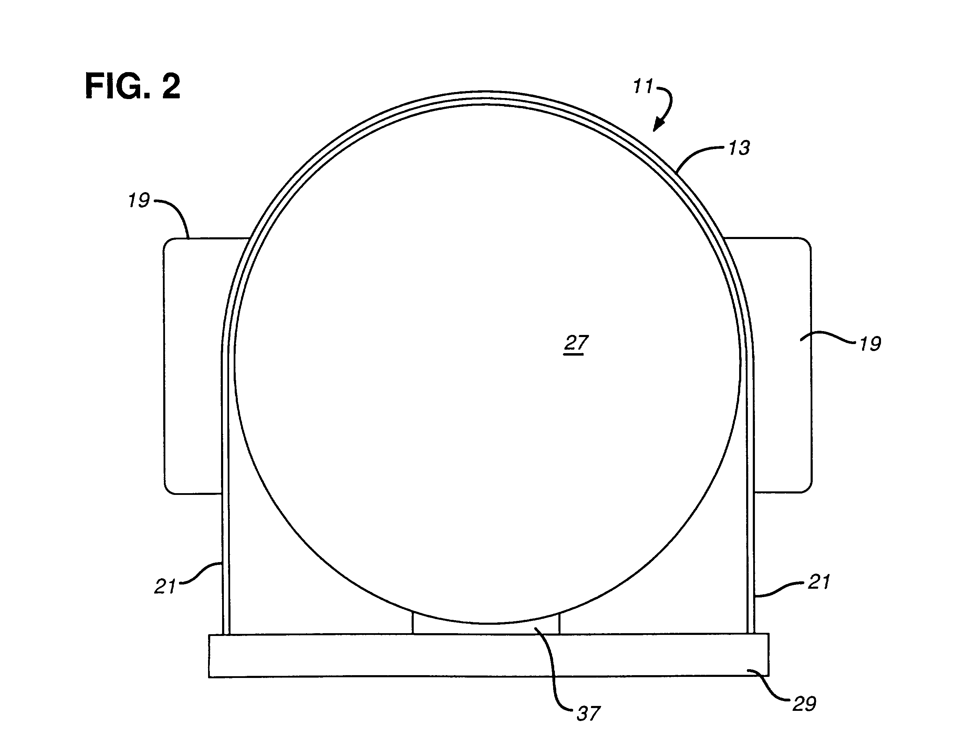

As illustrated in Fig. 2, the door 29 also includes a bumper 37 that is employed to hold the wafers in place when the door 29 is engaged with the raised periphery 23. Bumper 37 is preferably formed of a semi- rigid, or resilient, material that gives, or suffers deformation, slightly when placed up against the wafer 27 located in the grooves 25 within housing 13. To avoid contamination of wafers, the bumper 37 is of a material that will not produce any particulate matter during use.

The sealing mechanism includes an outside ring in the form of a rubber gasket or O-ring that forms a seal between the housing 13 and the door 29, when the door 29 is coupled to a groove 39 associated with the raised periphery 23 of the housing 13. According to the illustrated embodiment of the present invention, the groove 39 can be made of rubber or some other polymer to form a seal when the door 29 is coupled to the raised periphery 23. Raised periphery 23 may be formed as an integral part of the housing 13, or may be part of an insert or liner associated with the grooves 25 found within housing 13. The seal created is one that prevents particles from entering the interior of the housing 13. In normal use, the air pressure within housing 13 may be greater than the outside pressure during transportation of wafers within housing 13. This seal may be an airtight seal according to the present invention.

According to the illustrated embodiment of the present invention, the housing 13 has a dimension of about 1 foot and 7/16 inches (31.58cm) from the front to back, and has a sidewall 21 that is about 1/4 inches (0.64cm) thick, and that is configured to hold the wafer 27 that has a 6 inch (15.24cm) radius. The width of the housing 13 is about 1 foot and 3/4 inches (32.38cm) between the exterior surfaces thereof. Door 29 is about 1 foot and 1/4 inches (31.12cm) wide and 7 inches (17.78cm) tall in the depicted embodiment. Of course, those of ordinary skill in the art will realize that other dimensions may be employed depending on wafer size, materials used, and other factors specific to the particular type of apparatus for handling the pods.

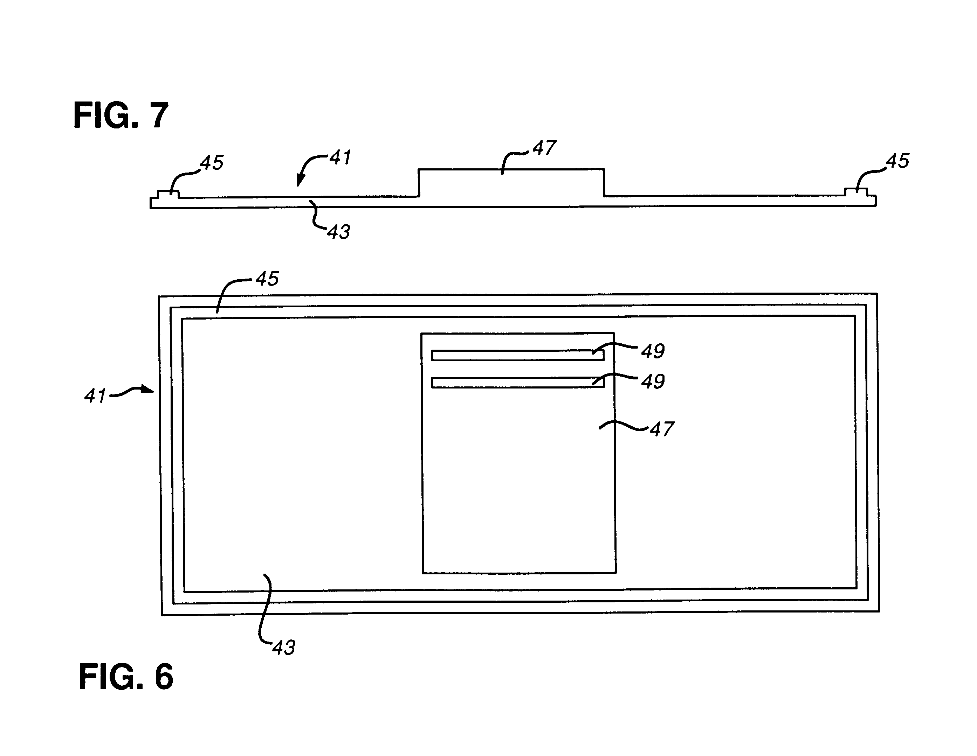

Turning now to Figs. 6 and 7, a top and side view of a door liner for a sealing mechanism are depicted according to the present invention. Liner 41 includes a planar section 43 that has an O-ring type seal 45 and a bumper 47. O-ring 45 also may be a rubber gasket according to the present invention. The liner 41 may be made from polyvinyl chloride ("PVC") and molded such that wafers fit into slots 49 formed in the bumper 47. The Bumper 47 is arranged to apply sufficient pressure to the radial edges of wafers 27 to keep them from moving within housing 13. If a planar surface is employed for bumper 47, the point contact on wafers 27 would be smaller, but pressure applied to secure the wafers would be about the same.

Alternatively, two bumpers equally spaced from the centre of the liner 41 may be employed according to the present invention. Other numbers or configurations of bumpers with or without slots or other retaining means may be employed to aid in preventing movement of wafers within the pod. Liner 41 is located on the door 29 such that when the door 29 is placed over the raised periphery 23, a seal preventing particles from entering housing 13 is formed according to the present invention.

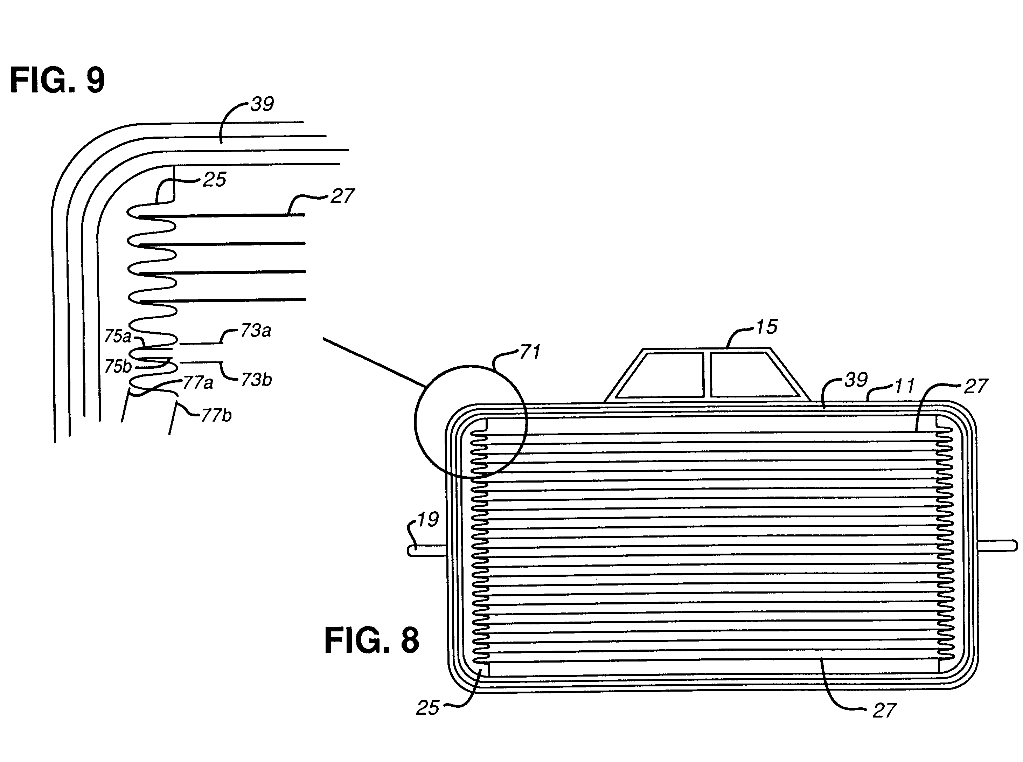

In Fig. 8, a front view of the apparatus 11, as depicted in Figs. 1-6, is illustrated without the door 29. As can be seen, 25 wafers 27 may be stored within housing 13. Fig. 9 shows an enlarged view of section 71 of Fig. 8. In this illustration, a more detailed view of the grooves 25 is provided. As can be seen, the wafers 27 may be slidably placed within the grooves 25. In this depicted example, a distance of 5/32 inches (0.39cm) separates lines 73a and 73b in grooves 25. A distance of 1/16 inche (0.16cm) separates lines 75a and 75b, while 25/64 inche (0.99cm) separates lines 77a and 77b in the depicted example. In the depicted example, wafer 27 is a wafer that is 12 inches (30.48cm) in diameter.

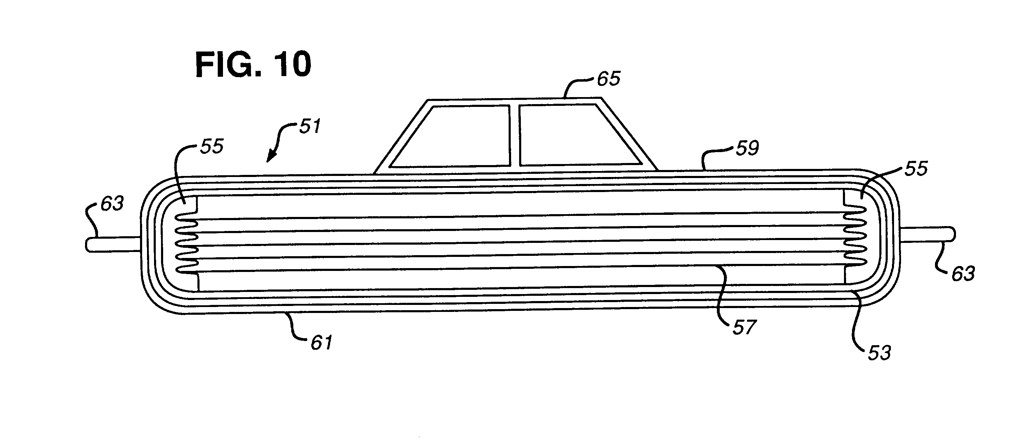

Turning next to Fig. 10, an apparatus 51 embodying the present invention is illustrated including wedge shaped grooves 55 for holding wafers 57 within housing 59. In the depicted example, liner 53 includes a raised periphery 61 that is employed to form a seal when a door (not shown) is coupled thereto according to the present invention. Apparatus 51 is a five wafer pod according to the present invention. Wafer pod 51 also includes projections 63 and handle 65 that are employed for transporting and handling the wafer pod 51.

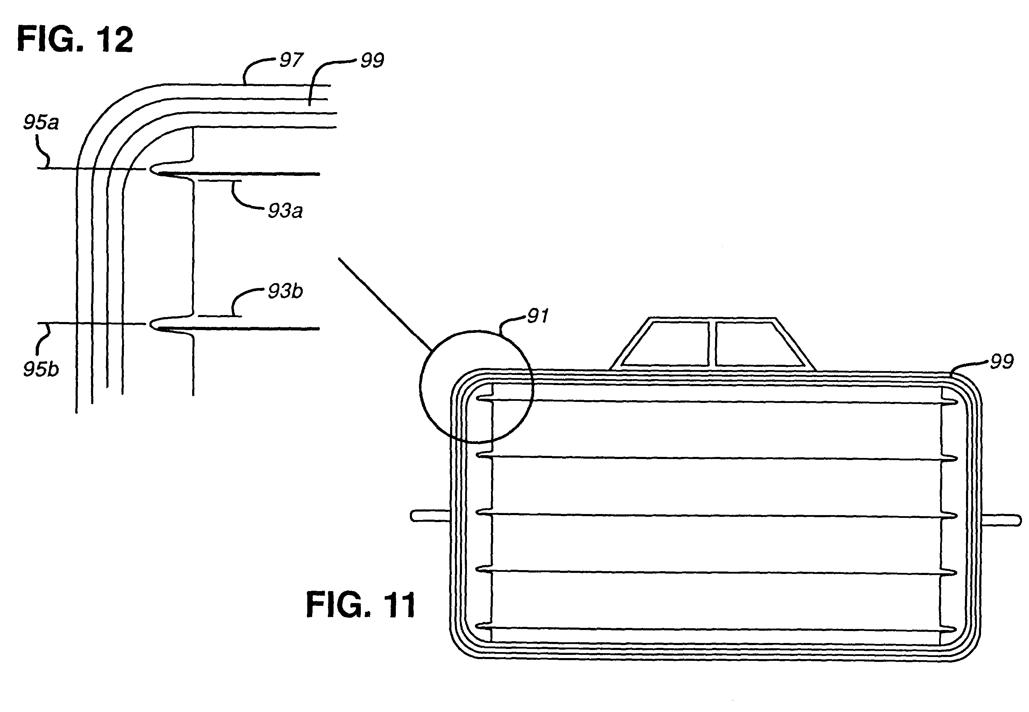

With reference now to Fig. 11, an example of an apparatus for holding five wafers according to the present invention is illustrated. Fig. 12 is an enlarged view of section 91 of Fig. 11. A distance of 1 and 15/64 inches (3.13cm) separates lines 93a and 93b, and a distance of 1 and 25/64 inches (3.53cm) separates lines 95a and 95b. Raised periphery 97 includes a groove 99, which is adapted to receive an O-ring type seal, such as O-ring 43, depicted in Figs. 6 and 7, to form a seal when a door is placed over the raised periphery according to the present invention. Although dimensions have been recited for various components, those of ordinary skill in the art will realize that these dimensions can be readily altered depending on the use and size of the wafers.

According to a particular advantage of the present invention, equipment needed to handle wafers using the present invention can be simpler because additional equipment required to handle cassettes can be eliminated. Also, storage space required to store pods according to the present invention would be less than that used for current pods containing the same number of the same sized wafers. In addition, the weight of the pod can be decreased as compared to pods presently used.

While the invention has been particularly shown and described with reference to preferred embodiments, it will be understood by those skilled in the art that the invention is not restricted to the details of the illustrated embodiments.

## Claims

1. Apparatus (11) for storing and carrying a plurality of wafers (27) comprising portable housing means (13) including an exterior with a portal leading to an interior, the portal being configured to receive the plurality of wafers (27) and characterized by receiving means (25), mounted in the interior of the portable housing means (13), for receiving the plurality of wafers (27), and sealing means (29,41) for creating a seal over the portal.

2. Apparatus as claimed in Claim 1, wherein the receiving means (25) includes grooves configured to receive the plurality of wafers (27).

3. Apparatus as claimed in Claim 2, wherein the grooves comprise wedge shaped grooves (25).

4. Apparatus as claimed in Claim 2 or 3, wherein the grooves (25) comprise part of an insert mounted within the portable housing means (13).

5. Apparatus as claimed in Claim 2 or 3, wherein the grooves comprise an integral part of the portable housing means (13).

6. Apparatus as claimed in anyone of Claims 2 to 5, wherein the housing means (13) contains a first interior sidewall and a second interior sidewall, the first interior sidewall being substantially parallel to the second interior sidewall and wherein a first plurality of grooves is located on the first interior sidewall and an opposing plurality of grooves is located along the second interior sidewall.

7. Apparatus as claimed in Claim 6, wherein the first plurality of grooves and the opposing plurality of grooves are aligned parallel to a plane and wherein a wafer (27) placed between the first portion of the plurality of the opposing grooves (25) and the remaining portion of the plurality of the opposing grooves is positioned parallel to the plane.

8. Apparatus as claimed in any one of the preceding claims, wherein the door (29) has an external side and an internal side and further comprising a bumper (37)located on the internal side of the door, the bumper being configured to hold wafers (27) within said receiving means (25) when the door (29) is coupled to the portable housing means (13).

9. Apparatus as claimed in any one of the preceding claims, wherein the sealing means is associated with a door (29) that is adapted to be attached to the portal and which has a gasket for creating an airtight seal when the door is attached to the portal.

10. Apparatus as claimed in any one of Claims 1 to 8, wherein said sealing means (41) is arranged to be placed between the door (29) and the portal, wherein the seal is created when the door (29) is coupled to the portal with the sealing means (41) located between the door (29) and the portal.
